# EUROPEAN PATENT APPLICATION

(11) **EP 4 791 177 A1**
(43) Date of publication of application: **12.08.2026**
(21) Application number: 26156274.8
(22) Date of filing: 04.02.2026
(51) Int. Cl.: H10W 40/73, H10W 40/20, H10W 40/25, H10W 40/47

(54) **VAPOR CHAMBER FOR SEMICONDUCTOR PACKAGE MODULE AND SEMICONDUCTOR PACKAGE MODULE AND POWER CONVERSION DEVICE INCLUDING THE SAME**

(30) Priority: 07.02.2025 KR 20250015771
(71) Applicant: LX Semicon Co., Ltd., Daejeon 34027 (KR)
(72) Inventor: CHOI, Hyung Kyu, 34027 Daejeon (KR); LEE, Yun-Tae, 34027 Daejeon (KR); HAN, Young Soo, 34027 Daejeon (KR)
(74) Representative: Ter Meer Steinmeister & Partner

(57) **Abstract**

A vapor chamber for a semiconductor package module according to an embodiment may include a lower metal plate, a hollow structure, and an upper metal plate that are sequentially disposed. The lower metal plate may include a first plate, a second plate, and a third plate that are sequentially disposed. A thermal expansion coefficient of the second plate may be less than the thermal expansion coefficient of the first plate or the third plate.

## Description

### BACKGROUND

### Field of the Disclosure

The embodiment relates to a vapor chamber for semiconductor package module and a semiconductor package module and power conversion device including the same.

### Description of the Background

As the performance of electric and electronic products progresses, semiconductor packages in which multiple semiconductor devices are disposed on a circuit board are utilized, and semiconductor packages have the advantage of efficiently using the mounting area of semiconductor devices and transmitting high-speed signals through a short signal transmission path between semiconductor devices.

Meanwhile, one of the industries with the fastest growth rate in the semiconductor market recently is the field of data sensor technology using AI semiconductors. In the data centers, the use of AI semiconductors that consume incomparably high power compared to the past is increasing, so interest in heat dissipation technology of semiconductor packages is very high.

Accordingly, the semiconductor and package market in the data center field, which is currently undergoing high growth, is applying many new technologies to secure heat dissipation technology.

In addition, 1200V, 200A high-voltage/high-power SiC power conversion modules are being used to improve the performance of hybrid and electric vehicles and for autonomous vehicles. During the operation of these high-performance electric vehicles, the operating temperature of the power semiconductor devices is to be implemented at an average of 300°C or higher, and the maximum instantaneous operating temperature is 350°C to 700°C, which is an ultra-high temperature usage state.

In these ultra-high temperature, high voltage, and high current operating environments, the existing bonding materials themselves may be re-melted, and the heat trap phenomenon may occur due to the pores present in the bonding area, which may rapidly deteriorate the life of the power semiconductor module, and cause thermal runaway, which may lead to the destruction of the power semiconductor devices and seriously affect the safety of the driver.

Recently, various heat dissipation components and heat dissipation modules such as heat sinks, heat dissipation plates, heat pipes, and vapor chambers are being studied to solve the heat generation problem of electronic devices such as AI semiconductors and power semiconductor modules.

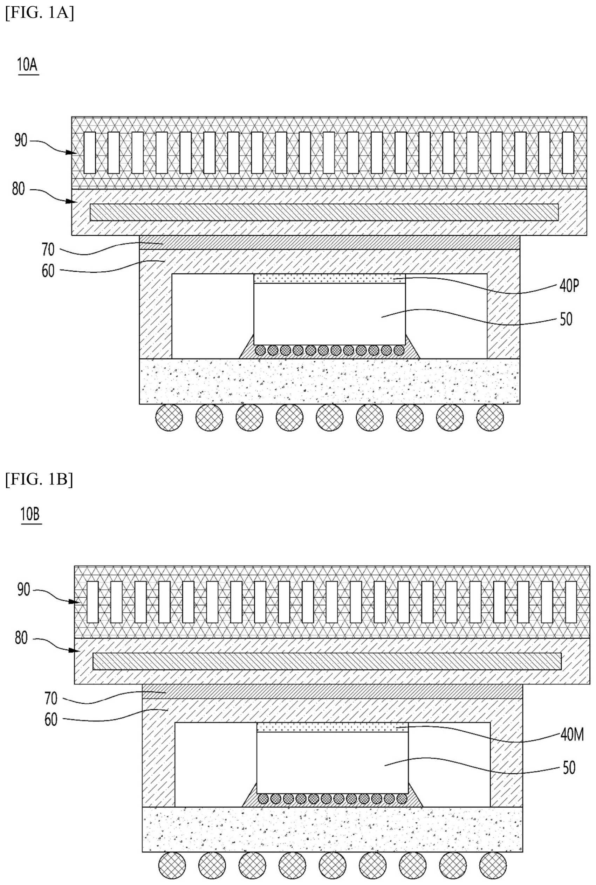

FIG. 1A is a drawing of a semiconductor package module (10A) of the first comparative example including a vapor chamber being studied internally.

The semiconductor package module (10A) of the first comparative example includes an electronic device (50), a metal lid (60), a vapor chamber (80), and a heat sink (90). In order to release heat generated from the electronic device (50) upward, a metal lid (60) is disposed on the electronic device (50), and the electronic device (50) and the metal lid (60) may be bonded by a first-first adhesive layer (40P).

In addition, a vapor chamber (80) and a heat sink (90) are disposed on the metal lid (60), and the metal lid (60) and the vapor chamber (80) may be bonded with a second adhesive layer (70).

Meanwhile, in the semiconductor package module (10A) of the first comparative example, the first-first adhesive layer (40P) is formed of a polymer-based material.

However, the first-first adhesive layer (40P) of the polymer-based material has a low thermal conductivity, so that the heat generated from the electronic device (50) does not spread and is concentrated in the center, which reduces the heat dissipation efficiency. Accordingly, the semiconductor package module (10A) of the first comparative example has a problem in that the temperature of the electronic device (50) increases, so the driving power is to be lowered to down the temperature of the electronic device (50) itself, and the performance is lowered to 30% or less.

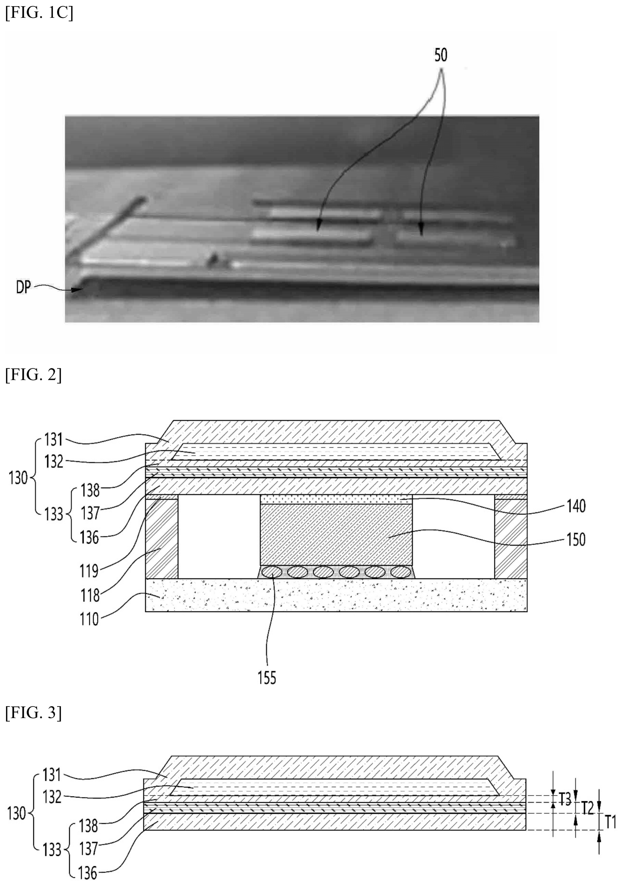

Next, FIG. 1B is a drawing of a semiconductor package module (10B) of the second comparative example including a vapor chamber to be studied internally, and FIG. 1C is a photograph of a delamination problem (DP) in the semiconductor package module (10B) of the second comparative example.

Unlike the first comparative example, in the semiconductor package module (10B) of the second comparative example, a method of forming the first-second adhesive layer (40M) with a metal material was studied to improve the efficiency of transferring heat generated from the electronic device (50) upward. However, there is a difference in the coefficient of thermal expansion between the metal lid (60) and the electronic device (50), and when the temperature of the electronic device (50) increases rapidly, warpage occurs, which causes cracks and voids to occur in the first-second adhesive layer (40M), resulting in a problem (DP) of delamination in the first-second adhesive layer (40M).

Accordingly, existing technologies attempt to employ a metal adhesive layer to efficiently transfer heat generated from electronic devices upward, but face the problem of a technical contradiction in which delamination occurs in the metal adhesive layer due to a difference in thermal expansion coefficient.

### SUMMARY

Accordingly, the present disclosure is directed to a vapor chamber for semiconductor package module and a semiconductor package module and power conversion device including the same that substantially obviates one or more of problems due to limitations and disadvantages described above.

One of the technical objects of the embodiment is to solve the problem of a technical contradiction in which delamination occurs in the metal adhesive layer due to a difference in thermal expansion coefficient while efficiently transferring heat generated from electronic devices upward by using a metal adhesive layer. The technical objects of the embodiment are not limited to those described in this item, and include those that may be understood through the description of the invention.

A vapor chamber for a semiconductor package module according to an embodiment may include a lower metal plate (133), a hollow structure (132), and an upper metal plate (131) that are sequentially disposed, and the lower metal plate (133) may include a first plate (136), a second plate (137), and a third plate (138) that are sequentially disposed.

A thermal expansion coefficient of the second plate (137) may be less than that of the first plate (136) or the third plate (138).

A thickness of the first plate (136) may be greater than that of the third plate (138).

The second plate (137) may be disposed so as to be closer to the upper surface than the lower surface of the lower metal plate (133).

The lower plate may further include a thermal conductive plug (139) within the second plate (137).

The thermal conductive plug (139) may have higher thermal conductivity than the second plate (137), and the thermal conductive plug (139) may have a lower thermal expansion coefficient than the second plate (137).

In addition, a semiconductor package module including a vapor chamber according to an embodiment may include a substrate (110), an electronic device (150) disposed on the substrate (110), and a vapor chamber (130) disposed on the electronic device (150).

The vapor chamber (130) may include a lower metal plate (133), a hollow structure (132), and an upper metal plate (131) that are sequentially disposed. And the lower metal plate (133) may include a first plate (136), a second plate (137), and a third plate (138) that are sequentially disposed in an upward direction.

The thermal expansion coefficient of the second plate (137) may be less than the thermal expansion coefficient of the first plate (136) or the third plate (138).

In addition, the embodiment further may include a first adhesive layer (140) that is disposed between the electronic device (150) and the vapor chamber (130), and the first adhesive layer (140) may include a metal material.

The thermal expansion coefficient of the second plate (137) may be greater than or equal to the thermal expansion coefficient of the electronic device (150).

The thickness of the first plate (136) may be greater than the thickness of the third plate (138).

The second plate (137) may be disposed so as to be adjacent to the upper surface of the lower metal plate (133) rather than the lower surface.

The second plate (137) may include a metal material or ceramic material having a thermal expansion coefficient within a range of 4.0x10⁻⁶/°C to 17x10⁻⁶/°C.

The lower plate may further include a thermal conductive plug (139) within the second plate (137).

The thermal conductive plug (139) may have higher thermal conductivity than the second plate (137), and the thermal conductive plug (139) may have a lower thermal expansion coefficient than the second plate (137).

In addition, a semiconductor package module including a vapor chamber according to an embodiment may include a substrate (110), an electronic device (150) disposed on the substrate (110), a vapor chamber (130) disposed on the electronic device (150), and a first adhesive layer (140) disposed between the electronic device (150) and the vapor chamber (130).

The vapor chamber (130) may include a lower metal plate (133), a hollow structure, and an upper metal plate (131) disposed sequentially. And the lower metal plate (133) may include a first plate (136), a second plate (137), and a third plate (138) disposed sequentially in an upward direction.

The thickness of the first plate (136) may be greater than the thickness of the third plate (138).

In addition, the embodiment may further include a first adhesive layer (140) disposed between the electronic device (150) and the vapor chamber (130).

The first adhesive layer (140) may include a metal material, and the thermal expansion coefficient of the second plate (137) may be less than the thermal expansion coefficients of the first and third plates.

The lower plate may further include a thermal conductive plug (139) within the second plate (137).

The thermal conductive plug (139) may have higher thermal conductivity than the second plate (137), and the thermal conductive plug (139) may have a lower thermal expansion coefficient than the second plate (137).

In addition, the power conversion device according to the embodiment may include any one of semiconductor package modules.

According to an embodiment, by using a metal adhesive layer, it is possible to solve the technical contradiction problem of delamination occurring in the metal adhesive layer due to a difference in thermal expansion coefficient while efficiently transmitting heat generated from an electronic device upward.

For example, referring to FIG. 2, the embodiment has a special technical effect that can solve the technical contradiction problem that delamination occurs in the metal bonding layer due to the difference in the coefficient of thermal expansion by controlling the coefficient of thermal expansion of the lower metal plate (133) of the vapor chamber (130) in contact with the electronic device (150) while efficiently transmitting the heat generated from the electronic device upward by using a metal bonding layer including a metal material as the first bonding layer (140).

In addition, according to the embodiment, when manufacturing the vapor chamber (130), a material capable of reducing the difference in the coefficient of thermal expansion (CTE) at the surface in contact with the electronic device (150) is included, and due to the reduction in the difference in the coefficient of thermal expansion, deformation between the electronic device and the vapor chamber (130) due to temperature change can be minimized, so that reliability and heat dissipation efficiency can be significantly improved by using a metal-based adhesive layer with high hardness and high thermal conductivity without delamination, thereby providing a complex technical effect.

In addition, according to the embodiment, there is a complex technical effect in which the heat generated from the electronic device can be rapidly diffused to further improve heat dissipation performance, while the warpage problem of the vapor chamber in contact with the electronic device can be prevented, thereby further improving reliability.

For example, referring to FIG. 3, since the first plate (136) adjacent to the electronic device (150) in the vapor chamber (130) is formed greater than the third plate (138), heat generated from the electronic device (150) can be quickly dissipated to further improve heat dissipation performance.

In addition, since the first thickness (T1) of the first plate (136) is controlled to be greater than the third thickness (T3) of the third plate (138), the second plate (137) may be disposed to be biased toward the upper region based on the horizontal center within the lower metal plate (133). Accordingly, the thermal expansion coefficient of the metal material disposed on the upper side of the second plate (137) and the thermal expansion coefficient of the metal material disposed below the second plate (137) may be disposed to be symmetrical with respect to the second plate (137). Therefore, the embodiment has a technical effect that the vapor chamber (130) can prevent warpage of the vapor chamber by making the upper and lower thermal expansion coefficients symmetrical based on the second plate (137), and prevent peeling of the first adhesive layer, thereby further improving reliability.

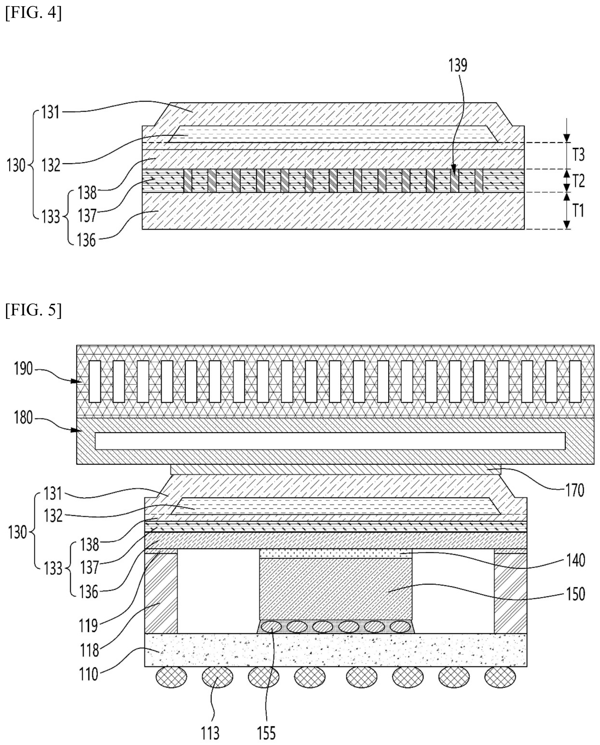

In addition, referring to FIG. 4, the vapor chamber according to the second embodiment may further include a thermal conductive plug (139) in the second plate (137), thereby providing a complex technical effect of improving heat dissipation performance and reliability.

For example, the second plate (137) may include a thermal conductive plug (139) filling a hole that penetrates the upper and lower portions, and the material of the thermal conductive plug (139) may be filled with a metal material having higher thermal conductivity than the material of the second plate (137).

Accordingly, the heat generated from the electronic device can be efficiently transferred from the first plate (136) to the third plate (138) through the second plate (137) and the thermal conductive plug (139), and the second plate (137) of the vapor chamber comprehensively may include a material having a thermal expansion coefficient higher than that of the electronic device, thereby minimizing thermal deformation of the vapor chamber (130) due to a decrease in the difference in the thermal expansion coefficient, thereby improving reliability and further enhancing heat dissipation performance.

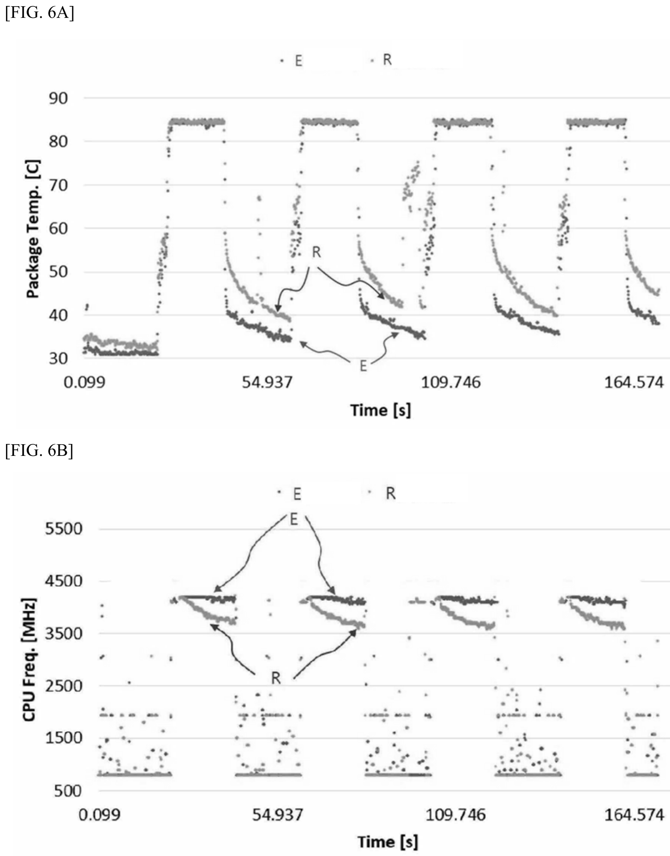

In addition, referring to FIG. 6A, embodiment (E) shows a significantly improved heat dissipation performance, so that the temperature of the semiconductor chip can be maintained lower, and even when the temperature is increased for operation, it drops to a lower temperature more quickly.

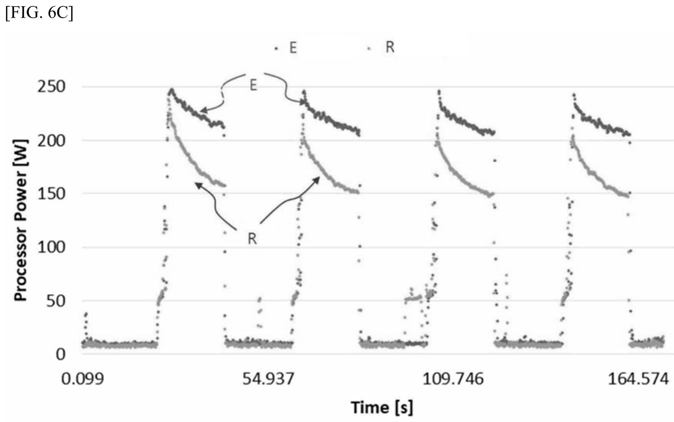

In addition, when the embodiment (E) and the comparative example (R) reach the same temperature during the operation of the CPU chip, the embodiment (E) has a special technical effect that it can exhibit higher performance and higher efficiency by expressing a higher clock frequency and power consumption while maintaining the same operating temperature due to the very efficient heat dissipation efficiency as shown in FIGS. 6B and 6C.

For example, referring to FIG. 6B, in the case of the comparative example (R), since the heat dissipation efficiency is low, the clock frequency of the CPU chip is lowered in order to extend the life of the CPU chip, and in the comparative example (R), the clock frequency decrease is large, so there is a problem that the performance of the CPU chip is significantly reduced.

On the other hand, in the case of the embodiment (E), the heat dissipation performance is significantly improved when the semiconductor package module including the vapor chamber according to the embodiment is applied, so the decrease in the clock frequency of the CPU chip is almost zero or very small compared to the comparative example (R), so there is a special technical effect that the performance of the CPU chip can be maximized.

Also, referring to FIG. 6C, in the case of Comparative Example (R), since the heat dissipation efficiency is low, the power of the CPU chip is lowered to extend the life of the CPU chip, and in this case, in Comparative Example (R), the processor power reduction is very large, so there is a problem that the performance of the CPU chip is significantly reduced.

On the other hand, in Embodiment (E), the heat dissipation performance is significantly improved when a semiconductor package module including a vapor chamber is applied, so the reduction in power consumption over time is almost zero or very small compared to Comparative Example (R), so there is a special technical effect that can maintain high performance of the CPU chip.

The technical effects of the Embodiment are not limited to those described in this item, and include those that may be understood through the description of the invention.

### BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain the principle of the disclosure.

In the drawings:
FIG. 1A is a drawing of a semiconductor package module (10A) of Comparative Example 1 including a vapor chamber that is studied internally.
FIG. 1B is a drawing of a semiconductor package module (10B) of Comparative Example 2 including a vapor chamber that is studied internally.
FIG. 1C is a photograph of a delamination problem (DP) in a semiconductor package module (10B) of the second comparative example.
FIG. 2 is a cross-sectional view of a semiconductor package module including a vapor chamber for a semiconductor package module according to an embodiment.
FIG. 3 is a drawing showing in detail a vapor chamber for a semiconductor package module according to the embodiment of FIG. 2.
FIG. 4 is a drawing showing a vapor chamber for a semiconductor package module according to the second embodiment.
FIG. 5 is a drawing showing a semiconductor package module including a vapor chamber for a semiconductor package module according to the third embodiment.
Figs. 6A to 6C are graphs showing the package temperature, the operating frequency of the CPU chip, and the power consumption of the processor over time for the embodiment (E) and the comparative example (R), respectively.

### DETAILED DESCRIPTION

Hereinafter, the aspects disclosed in this specification will be described in detail with reference to the attached drawings. The suffixes 'module' and 'part' used for elements in the following description are given or used interchangeably in consideration of the ease of writing the specification, and do not have distinct meanings or roles in themselves. In addition, the attached drawings are intended to facilitate easy understanding of the aspects disclosed in this specification, and the technical ideas disclosed in this specification are not limited by the attached drawings. In addition, when an element such as a layer, region, or substrate is mentioned as existing 'on' another element, this includes that it may be directly on the other element, or that other intermediate elements may exist in between.

In the specification or claims, the meaning of "an element A includes at least one of a, b, and/or c" may include ① when the element A includes the element a, ② when the element A includes the element b, ③ when the element A includes the element c, ④ when the element A includes the elements a and b, ⑤ when the element A includes the elements b and c, ⑥ when the element A includes the elements a and c, and ⑦ when the element A includes all elements of a, b, and c. The singular expression includes the plural expression as well as the singular expression, unless the context clearly indicates otherwise. For example, the meaning of "element A includes one structure" may include the meaning of "element A includes one or more structures."

### (Example)

FIG. 2 is a cross-sectional view of a semiconductor package module including a vapor chamber for a semiconductor package module according to an embodiment. Hereinafter, 'semiconductor package module including a vapor chamber for a semiconductor package module' will be abbreviated as 'semiconductor package module'.

Referring to FIG. 2, the semiconductor package module according to the embodiment may include a substrate (110), an electronic device (150), and a vapor chamber (130). In detail, the substrate (110) may include at least one of a plurality of insulating layers, wiring layers, and via electrodes. The substrate (110) may be a semiconductor package substrate. The semiconductor package to which the embodiment is applied may be one of FC-BGA (Flip Chip Ball Grid Array), CSP (Chip Scale Package), FC-CSP (Flip Chip-Chip Scale Package), POP (Package On Package), and SIP (System In Package), but is not limited thereto. The substrate (110) may further include an interposer substrate (not shown) to mount an electronic device (150) on the interposer substrate, but is not limited thereto.

In addition, the electronic device (150) may be a semiconductor device. For example, the electronic device (150) may be a high-performance semiconductor such as an AI semiconductor, a processor for a data center, a power semiconductor for an electric vehicle inverter, and the like, but is not limited thereto.

For example, the electronic device (150) may include a semiconductor device that is an active device or a passive device. The active device may be a semiconductor chip in the form of an integrated circuit (IC) in which hundreds to millions of devices are integrated into one chip. In addition, the semiconductor device may be a logic chip, a memory chip, etc. For example, the logic chip may be a graphic processor (GPU), a central processor (CPU), a digital signal processor, an encryption processor, a microprocessor, an analog-to-digital converter, etc.

In addition, the memory chip to which the embodiment is applied may be a stack memory such as HBM. In addition, the memory chip may include a volatile memory such as DRAM, a non-volatile memory such as ROM, a flash memory, etc.

In addition, the semiconductor package may be a smart phone, a personal digital assistant, a digital video camera, a digital still camera, a vehicle, a high-performance server, a network system, a computer, a monitor, a tablet, a laptop, a netbook, a television, a video game, a smart watch, an automotive, etc. However, the present invention is not limited thereto, and it is obvious that the semiconductor package may be any other electronic device that processes data.

In addition, the electronic device (150) may be a power semiconductor including a drain electrode, a semiconductor epi layer, a source electrode, and a gate electrode. For example, the epi layer of the power semiconductor to which the embodiment is applied can include Si or SiC, but is not limited thereto. When the electronic device (150) is a power semiconductor device including Si or SiC, the thermal expansion coefficient of the power semiconductor may be 4.0×10⁻⁶/°C to 4.5×10⁻⁶/°C, but is not limited thereto.

The electronic device (150) may be electrically connected to the substrate (110) through a connection portion (155) including solder.

Next, the vapor chamber (130) may include an upper metal plate (131), a hollow structure (132), and a lower metal plate (133). The upper metal plate (131) and the lower metal plate (133) may be bonded at both ends, and a hollow structure (132) may be disposed between them. In FIG. 2, one side of the upper metal plate (131) is illustrated to have an incline, but is not limited thereto.

For example, the upper metal plate (131) of the vapor chamber (130) of the embodiment may be formed by using a material with excellent ductility, such as Cu, so that the upper metal plate (131) may be bent to be joined to the lower metal plate (133).

In addition, the vapor chamber (130) of another embodiment may have a middle metal plate (not shown) in which a hollow structure (132) is formed, and a structure in which the middle metal plate is interposed between the upper metal plate (131) and the lower metal plate (133) and then bonded may also be possible.

Referring to FIG. 2, the lower metal plate (133) of the vapor chamber (130) of the embodiment may include a plurality of plates. In detail, the lower metal plate (133) may include a first plate (136), a second plate (137), and a third plate (138) that are disposed sequentially in a vertical direction. The lower metal plate (133) may be formed through a metal bonding or sintering process.

In addition, the first plate (136) and the third plate (138) may include the same material. In addition, the first plate (136) and the third plate (138) may include the same material as the upper metal plate (131). For example, the first plate (136), the third plate (138), and the upper metal plate (131) may include copper, but are not limited thereto. When the upper metal plate (131), the first plate, and the third plate (138) include copper, the thermal expansion coefficient may be 17×10⁻⁶/°C.

In addition, the second plate (137) may include a different material from the first plate (136) and the third plate (138). In detail, the second plate (137) may include a metal material or a ceramic material.

For example, when the second plate (137) may include a metal material, the thermal expansion coefficient of the metal material of the second plate (137) may be less than the thermal expansion coefficients of the metal materials of the first plate (136) and the third plate (138).

In addition, the thermal expansion coefficient of the metal material of the second plate (137) may be greater than or equal to the thermal expansion coefficient of the electronic device (150). Accordingly, the metal material of the second plate (137) may be a metal material having a thermal expansion coefficient within a range of 4.0×10⁻⁶/°C to 17×10⁻⁶/°C. For example, the second plate (137) may include, but is not limited to, gold (Ag), iron (Fe), nickel (Ni), platinum (Pt), molybdenum (Mo), tungsten (W), etc. The second plate (137) may be formed with a metal bond with the first plate (136) and the third plate (138).

In addition, the second plate (137) may include a ceramic material, and in this case, the ceramic material of the second plate (137) may be a ceramic material having a thermal expansion coefficient within a range of 4.0×10⁻⁶/°C to 17×10⁻⁶/°C. For example, the second plate (137) may include an inorganic material such as Al₂O₃, ZrO₂, ALN, Y₂O₃, etc., but is not limited thereto.

Accordingly, the embodiment may reduce the difference in the thermal expansion coefficient between the vapor chamber (130) and the electronic device (150) since the thermal expansion coefficient of the second plate (137) of the lower metal plate (133) is less than the thermal expansion coefficients of the first plate (136) and the third plate (138). Therefore, the embodiment can prevent thermal deformation of the vapor chamber (130) and the electronic device (150) as the difference in thermal expansion coefficient between the vapor chamber (130) and the electronic device (150) becomes smaller.

In addition, the embodiment may include a post (118) disposed on the substrate (110), and the post (118) may be disposed between the substrate (110) and the vapor chamber (130). In addition, the post (118) may be disposed to overlap the electronic device (150) in a horizontal direction.

The post (118) and the vapor chamber (130) may be bonded through a third adhesive layer (119). In addition, the post (118) can include a metal having high strength. The post (118) can prevent warpage of the vapor chamber (130) by contacting both ends of the vapor chamber (130), and has a technical effect of protecting the electronic device (150) from external contaminants such as moisture and dust.

The embodiment may include a post (118) disposed on a substrate (110), and a vapor chamber (130) may be disposed on the post (118) and the electronic device (150), and the vapor chamber (130) may be disposed in contact with the electronic device (150).

The embodiment has a special technical effect that can solve the problem of technical contradiction that cracks or voids occur in the metal adhesive layer due to the difference in thermal expansion coefficient by controlling the thermal expansion coefficient of the third plate (138) of the vapor chamber (130) in contact with the electronic device (150) while efficiently transferring heat generated from the electronic device upward by using a metal adhesive layer including a metal material as the first adhesive layer (140).

For example, the first adhesive layer (140) may include, but is not limited to, a Sn alloy adhesive layer, an In alloy adhesive layer, an Al alloy adhesive layer, etc. For example, the first adhesive layer (140) may include, but is not limited to, a SnxAgyCuz alloy adhesive layer, an InxAgy alloy adhesive layer, etc.

Also, according to the embodiment, when manufacturing the vapor chamber (130), a material capable of reducing the difference in the coefficient of thermal expansion (CTE) at the surface in contact with the electronic device (150) is included, and due to the reduction in the difference in the coefficient of thermal expansion, thermal deformation between the electronic device and the vapor chamber (130) due to temperature change can be minimized, so that reliability and heat dissipation efficiency can be significantly improved by using a metal-based adhesive layer with high hardness and high thermal conductivity without delamination, thereby providing a complex technical effect.

Next, FIG. 3 is a drawing showing in detail the vapor chamber (130) for a semiconductor package module according to the embodiment of FIG. 2. Referring to FIG. 3, the vapor chamber (130) may include an upper metal plate (131), a hollow structure (132), and a lower metal plate (133). In FIG. 3, the hollow structure (132) is illustrated as being empty, but may include a plurality of trench structures or a plurality of holes, and the plurality of trench structures or a plurality of holes may be filled with other materials.

For example, a working fluid inlet may be formed on one side of a hollow structure (132), a working fluid may be injected into the hollow structure, and the fluid inlet may be closed. The working fluid may be, but is not limited to, acetone, methanol, ethanol, or deionized water (DI-water).

According to an embodiment, as heat generated from an electronic device (150) is efficiently transferred to the lower metal plate (133) through the first adhesive layer (140), which is a metal adhesive layer, the working fluid may vaporize, absorb latent heat of vaporization, move toward the upper metal plate (131), and condense into a liquid while releasing latent heat of vaporization. The condensed working fluid may be absorbed into the trench structure of the hollow structure and move toward the lower metal plate (133).

In addition, in the embodiment, the lower metal plate (133) may include a first plate (136), a second plate (137) disposed on the first plate (136), and a third plate (138) disposed on the second plate (137). The second plate (137) may be interposed between the first plate (136) and the third plate (138).

The upper metal plate (131) and the lower metal plate (133) may include the same material. In addition, the first plate (136) and the third plate (138) may include the same material. The upper metal plate (131), the first plate (136), and the third plate (138) may include the same metal material, for example, copper (Cu), but are not limited thereto.

According to the embodiment, there is a complex technical effect that can further improve reliability by rapidly dissipating heat generated from the electronic device to further improve heat dissipation performance and preventing warpage of the vapor chamber in contact with the electronic device.

For example, as shown in FIG. 3, a first thickness (T1) of the first plate (136) in the lower metal plate (133) may be greater than a third thickness (T3) of the third plate (138). In addition, the first thickness (T1) of the first plate (136) may be greater than a second thickness (T2) of the second plate (137).

In addition, the second plate (137) may be disposed to be biased toward the upper region based on the horizontal center within the lower metal plate (133).

The second plate (137) may be positioned so as to be closer to the upper surface than the lower surface of the lower metal plate (133). Therefore, the embodiment has a technical effect of further improving heat dissipation performance by quickly dissipating heat generated from the electronic element (150) as the first plate (136) adjacent to the electronic element (150) is formed greater than the third plate (138).

In addition, based on the second plate (137) having a relatively large thermal expansion coefficient, the first thickness (T1) of the first plate (136) may be greater than the third thickness (T3) of the third plate (138) so that the thermal expansion coefficient of the metal material disposed on the upper side of the second plate (137) and the thermal expansion coefficient of the metal material disposed below the second plate (137) are symmetrical. Accordingly, the embodiment has a technical effect that the vapor chamber (130) has a coefficient of thermal expansion of the upper and lower parts symmetrical with respect to the second plate (137), thereby preventing warpage of the vapor chamber and preventing peeling of the first adhesive layer, thereby further improving reliability.

Next, FIG. 4 is a drawing showing a vapor chamber for a semiconductor package module according to the second embodiment. Referring to FIG. 4, the lower metal plate (133) of the vapor chamber (130) may include a first plate (136), a second plate (137) disposed on the first plate (136), and a third plate (138) disposed on the second plate (137). The second plate (137) may be interposed between the first plate (136) and the third plate (138).

Meanwhile, the vapor chamber according to the second embodiment may further include a thermal conductive plug (139) within the second plate (137), thereby providing a complex technical effect of improving heat dissipation performance and reliability.

For example, the thermal conductive plug (139) disposed within the second plate (137) may be disposed to penetrate the second plate (137). The second plate (137) may include a grid shape having upper and lower penetration holes, but is not limited thereto. In addition, the second plate (137) may include a thermal conductive plug (139) filling the upper and lower penetration holes, but is not limited thereto.

The thermal conductive plug (139) may be in contact with the upper surface of the first plate (136). In addition, the thermal conductive plug (139) may be in contact with the lower surface of the third plate (138). In addition, the thermal conductive plug (139) may include a plurality of pieces spaced apart horizontally within the second plate (137). The thickness of the thermal conductive plug (139) may be the same as the second thickness (T2) of the second plate (137).

The thermal conductive plug (139) material filling the hole of the second plate (137) may be filled with a metal material having a higher thermal conductivity than the material of the second plate (137). For example, the thermal conductive plug (139) may be filled with the same material as the first plate (136) or the third plate (138), but is not limited thereto. For example, the thermal conductive plug (139) may be filled with copper (Cu). Accordingly, the heat generated from the electronic device can be efficiently transferred from the first plate (136) to the third plate (138) through the second plate (137) and the thermal conductive plug (139). Therefore, there is a technical effect that heat conduction can be improved from the first plate (136) to the third plate (138), thereby further improving the heat dissipation performance.

In addition, according to the second embodiment, the second plate (137) of the vapor chamber may include a composite material having a thermal expansion coefficient higher than that of the electronic device, thereby minimizing the shape of the vapor chamber (130) due to a reduction in the difference in the thermal expansion coefficient, thereby further improving the reliability and heat dissipation performance.

Next, FIG. 5 is a drawing showing a semiconductor package module including a vapor chamber according to the third embodiment.

FIG. 5 may further include a second vapor chamber (180) and a heat sink (190) in the semiconductor package module of FIG. 2. Referring to FIG. 5, a second vapor chamber (180) may be disposed on a vapor chamber (130). The vapor chamber (130) and the second vapor chamber (180) may be bonded through a second adhesive layer (170). In addition, the second vapor chamber (180) may be greater than the horizontal width of the vapor chamber (130). The second adhesive layer (170) may include a metal adhesive layer, but is not limited thereto.

In addition, a heat sink (190) may be disposed on the second vapor chamber (180). Accordingly, the third embodiment has a technical effect of improving heat dissipation performance by spreading heat transferred through the vapor chamber (130) to a wider area.

The second vapor chamber (180) may adopt the technical features of the vapor chamber (130) described above. For example, the second vapor chamber (180) may include a fourth plate, a fifth plate, and a sixth plate disposed in a vertical direction, and a hollow structure may be disposed in the fifth plate. The fourth plate may be formed to be greater than the fifth plate and the sixth plate, but is not limited thereto.

FIGS. 6A to 6C are graphs showing the package temperature, the operating frequency of the CPU chip, and the power consumption of the processor over time for the embodiment (E) and the comparative example (R), respectively.

The embodiment (E) and the comparative example (R) may be, for example, a CPU chip, but is not limited thereto. The CPU chip of the embodiment (E) of FIGS. 6A to 6B may include the semiconductor package module including the vapor chamber according to the embodiment of FIGS. 2 to 5.

When the CPU chip of the embodiment (E) is applied with the semiconductor package module including the vapor chamber according to the embodiments of FIGS. 2 to 5, the heat dissipation performance can be significantly improved as shown in FIG. 6A, so that the temperature of the semiconductor chip can be maintained lower, and even when the temperature rises for operation, it shows the effect of quickly dropping to a lower temperature.

Specifically, when the CPU chip is driven, the temperature of the package rapidly increases due to the heat generation of the CPU chip. Afterwards, when the CPU chip stops driving, the temperature of the semiconductor package module decreases, and when the CPU chip is driven again, it reaches the peak temperature again.

Meanwhile, referring to FIG. 6A, in the case of the embodiment (E), it can be confirmed that the temperature decreases faster than in the comparative example (R) when the CPU chip is stopped driving due to the using the semiconductor package module including the vapor chamber according to the embodiment. In addition, while the embodiment (E) and the comparative example (R) reach the same temperature when the CPU chip is driven, the embodiment (E) has a special technical effect that it can exhibit higher performance and higher efficiency by expressing a higher clock frequency and power consumption while maintaining the same driving temperature due to the very efficient heat dissipation efficiency as shown in FIGS. 6B and 6C.

In addition, according to the embodiment, a more effective heat dissipation structure in contact with the semiconductor can provide a great effect on heat diffusion, and even if the size or performance of the heat dissipation structure of the subsequent structure is small or low, it can provide the same level of final heat dissipation performance, thereby also having the effect of reducing the overall cost.

Specifically, referring to FIG. 6B, when the CPU chip is driven, the temperature of the CPU chip increases according to the driving time, so in order to prevent the chip from being damaged by a further increase in temperature, there is an underclock function that forcibly lowers the clock frequency of the CPU chip.

For example, in the case of Comparative Example (R), since the heat dissipation efficiency is low, the clock frequency of the CPU chip is lowered in order to extend the life of the CPU chip. And in this case, in Comparative Example (R), the clock frequency decrease is large, and thus the performance of the CPU chip is significantly reduced.

On the other hand, in the case of Embodiment (E), when applying the semiconductor package module including the vapor chamber according to the embodiment, the heat dissipation performance can be significantly improved, and thus the clock frequency decrease is almost zero or very small compared to Comparative Example (R), and thus there is a special technical effect that can maximize the performance of the CPU chip.

In addition, referring to FIG. 6C, as the temperature of the CPU chip increases over time when the CPU chip is operated, the power consumption is forcibly lowered to suppress the temperature increase.

For example, in the case of Comparative Example (R), since the heat dissipation efficiency is low, the power of the CPU chip is lowered in order to extend the life of the CPU chip, and in Comparative Example (R), the processor power decrease is very large, and thus the performance of the CPU chip is significantly reduced.

On the other hand, Example (E) has a special technical effect that can maintain high performance of CPU chip because the heat dissipation performance can be significantly improved when applied to the semiconductor package module including the vapor chamber, and the decrease in power consumption over time can be much less than that of Comparative Example (R).

Although the above has been described with reference to the embodiments of the present invention, it will be easily understood by those skilled in the art that various modifications and changes may be made to the present invention without departing from the idea and scope of the present invention described in the scope of the following patent claims. [Explanation of reference signs]

| | | | |
|---|---|---|---|
| 60: | metal plate | 70, 170: | second adhesive layer |
| 80, 180: | vapor chamber | 90, 190: | heat sink |
| 110: | substrate | 118: | post |
| 119: third | adhesive layer | 130: | vapor chamber |
| 131: | upper metal plate | 132: | hollow structure |
| 133: | lower metal plate | 136: | first plate |
| 137: | second plate | 138: | third plate |
| 139: | hole | 140: | adhesive layer |
| 150: | electronic device | 155: | connection part |
| E: | Example | R: | Comparative Example |

## Claims

1. A vapor chamber for a semiconductor package module, the vapor chamber comprising:
a lower metal plate, a hollow structure, and an upper metal plate disposed sequentially;
wherein the lower metal plate comprises:
a first plate, a second plate, and a third plate disposed sequentially,
wherein a coefficient of thermal expansion of the second plate is less than the coefficient of thermal expansion of the first plate or the third plate.

2. The vapor chamber according to claim 1, wherein a thickness of the first plate is greater than that of the third plate.

3. The vapor chamber according to claim 1 or 2, wherein the second plate is disposed closer to an upper surface than a lower surface of the lower metal plate.

4. The vapor chamber according to any one of the preceding claims, wherein the lower plate further comprises a thermal conductive plug within the second plate,

5. The vapor chamber according to claim 4, wherein the thermal conductive plug has higher thermal conductivity than the second plate, and
wherein the thermal conductive plug has a lower coefficient of thermal expansion than the second plate,

6. A semiconductor package module including a vapor chamber, the semiconductor package module comprising:
a substrate;
an electronic device disposed on the substrate; and
a vapor chamber disposed on the electronic device;
wherein the vapor chamber comprises any one of vapor chamber according to one of claims 1 to 5.

7. The semiconductor package module according to claim 6, further comprising a first adhesive layer disposed between the electronic device and the vapor chamber, and
wherein the first adhesive layer comprises a metal material

8. The semiconductor package module according to claim 6 or 7, wherein the thermal expansion coefficient of the second plate is greater than or equal to the thermal expansion coefficient of the electronic device.

9. The semiconductor package module according to claim 6, 7 or 8, wherein a thickness of the first plate is greater than that of the third plate, and
wherein the second plate is disposed so as to be adjacent to an upper surface of the lower metal plate rather than the lower surface.

10. The semiconductor package module according to claim 6, 7, 8 or 9, wherein the second plate comprises a metal material or a ceramic material having a thermal expansion coefficient within a range of 4.0× 10⁻⁶/°C to 17×10⁻⁶/°C.

11. The semiconductor package module according to claim 6, 7, 8, 9 or 10, wherein the lower plate further comprises a thermal conductive plug within the second plate,
wherein the thermal conductive plug has higher thermal conductivity than the second plate, and
wherein the thermal conductive plug has a lower coefficient of thermal expansion than the second plate.

12. A semiconductor package module including a vapor chamber, the semiconductor package
module comprising:
a substrate;
an electronic device disposed on the substrate;
a vapor chamber according to one of claims 1 to 5 disposed on the electronic device; and
a first adhesive layer disposed between the electronic device and the vapor chamber,
wherein a thickness of the first plate is greater than that of the third plate.

13. The semiconductor package module according to claim 12, further comprising a first adhesive layer disposed between the electronic device and the vapor chamber,
wherein the first adhesive layer comprises a metal material, and
wherein a coefficient of thermal expansion of the second plate is less than that of the first and third plates.

14. The semiconductor package module according to claim 12 or 13, wherein the lower plate further comprises a thermal conductive plug within the second plate,
wherein the thermal conductive plug has higher thermal conductivity than the second plate, and
wherein the thermal conductive plug has a lower thermal expansion coefficient than the second plate.

15. A power conversion device including the semiconductor package module according to any
one of claims 6 to 14.
